(19) Europäisches Patentamt

European Patent Office

Office européen des brevets

(11) **EP 0 917 289 A2**

(12) **EUROPÄISCHE PATENTANMELDUNG**

(43) Veröffentlichungstag:
**19.05.1999 Patentblatt 1999/20**

(51) Int. Cl.⁶: **H03H 19/00**

(21) Anmeldenummer: **98121639.3**

(22) Anmeldetag: **12.11.1998**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **17.11.1997 DE 19750922**

(71) Anmelder:
**STMicroelectronics GmbH**
**85630 Grasbrunn (DE)**

(72) Erfinder:
• **Schambacher, Jörg**
  **81677 München (DE)**
• **Kirchlechner, Peter**
  **83104 Hohenthann (DE)**
• **Lübbe, Jürgen**
  **83553 Jacobneuharting (DE)**

(74) Vertreter: **Hirsch, Peter**
  **Kιunker Schmitt-Nilson Hirsch**
  **Winzererstrasse 106**
  **80797 München (DE)**

(54) **Integrierte Schaltung mit geschaltetem Kondensator**

(57)   In integrierten Schaltungen werden sogenannte Kondensatoren (switched capacitors; SC) beispielsweise zum Simulieren ohm'scher Widerstände verwendet. Hierzu wird der eine Belag des zu schaltenden Kondensators mit dem Eingangssignal über einen Transistorschalter (T1) gespeist, der an seinem Gate (G) als Steuersignal einen Impulszug mit vorbestimmter Frequenz empfängt. Um die parasitäre Kapazität des Transistorschalters zu kompensieren, liegt zwischen dem Transistorschalter und dem zu schaltenden Kondensator ein Kompensationsbauelement. Dieses ist als unvollständige Transistorstruktur (1/2-Transistor) ausgebildet, hat eine Drainzone (10) mit dem Transistorschalter (T1) gemeinsam und besitzt ein isoliertes Gate (18, 28). Damit ist die parasitäre Kapazität des Kompensationsbauelements hauptsächlich gegeben durch die Kapazität zwischen dem isolierten Gate (18, 28) und der Drain-Zone (10) und entspricht mithin der parasitären Kapazität (Cgd) des Transistorschalters (T1), wodurch eine vollständige Kompensation bei optimiertem Ladungstransfer erreicht wird.

FIG. 5

**Beschreibung**

Die Erfindung betrifft eine integrierte Schaltung mit mindestens einem geschalteten Kondensator, der zum Beispiel zum Simulieren eines ohm'schen Widerstands dient, und dessen einer Belag mit einem Signaleingang über mindestens einen Transistorschalter, der Source, Drain und Gate aufweist, gekoppelt ist, dessen Gate (G) ein Steuersignal in Form eines Impulszugs mit vorbestimmter Frequenz zugeführt wird, wobei zwischen dem Transistorschalter und dem einen Kondensatorbelag ein Kompensationsbauelement liegt, welches gegenphasig zu dem Transistorschalter angesteuert wird, um den Einfluß der wirksamen parasitären Kapazität des Transistorschalters zu kompensieren.

Es ist bekannt, in integrierten Schaltungen bestimmte Funktionen mit Hilfe von sogenannten geschalteten Kondensatoren (switched capacitors; SC) zu realisieren, beispielsweise die Funktion eines ohm'schen Widerstands. Bekanntlich errechnet sich die Impedanz eines Kondensators aus dem Reziprokwert des Produkts aus Frequenz und Kapazität. Dementsprechend werden zum Simulieren ohm'scher Widerstände integrierte Kondensatoren über Schalter angesteuert, so daß ein ständiger Umladevorgang am Kondensator stattfindet. Die Frequenz des Ansteuersignals ist auf die Kapazität des Kondensators so abgestimmt, daß die gewünschte Impedanz erreicht wird.

Werden ohm'sche Widerstände mit Hilfe geschalteter Kondensatoren simuliert, so läßt sich eine beträchtliche Chipbelegungsfläche einsparen, auch wenn man die für den Schaltvorgang benötigten Elemente berücksichtigt.

Zum Schalten des Kondensators verwendet man üblicherweise einen Feldeffekttransistor mit isoliertem Gate (IGFET), und man kann komplementäre Transistoren verwenden. Natürlich ist man in den meisten Fällen bestrebt, eine hohe Schaltgeschwindigkeit zu ermöglichen.

Dies läuft in der Praxis darauf hinaus, den gesamten Ladungstransfer möglichst gering zu halten und die Ansprechgeschwindigkeit auf die impulsförmigen Ansteuersignale möglichst hoch zu machen.

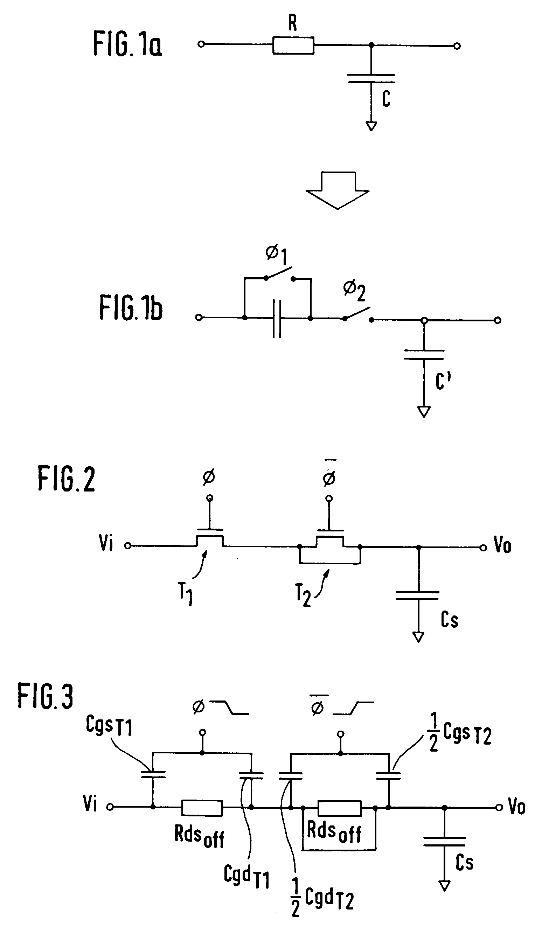

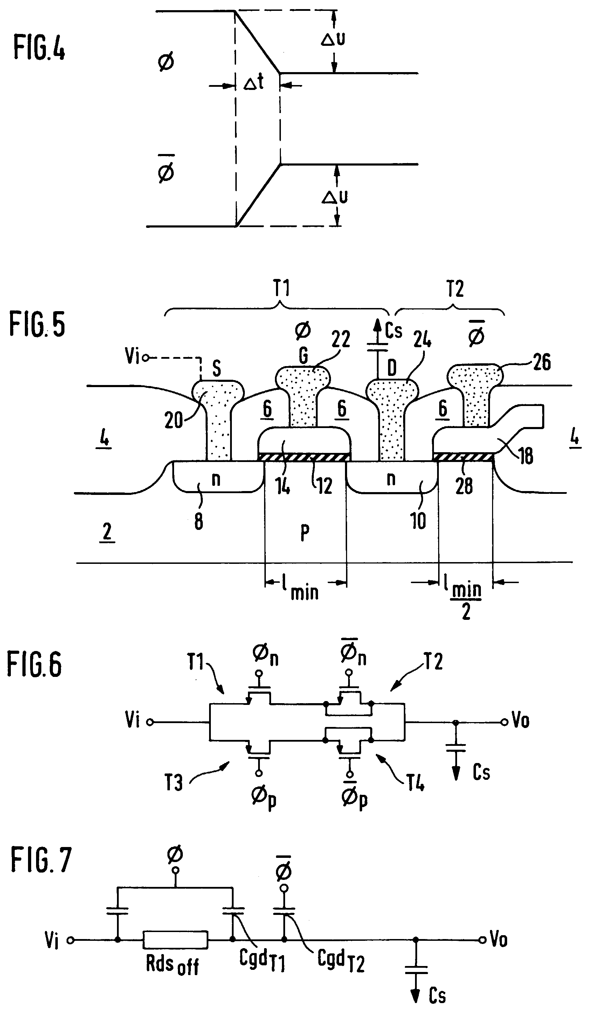

Verwendet man zum Schalten des Transistors beispielsweise einen einfachen Feldeffekttransistor, der mit dem impulsförmigen Signal angesteuert wird, und der mit seiner Source-Drain-Strecke zwischen dem Signaleingang und einem Belag des Kondensators liegt, so spielen parasitäre Effekte eine nicht zu vernachlässigende Rolle. Dies soll im folgenden näher erläutert werden, wozu auf die beiliegenden Figuren 1 und 2 der Beschreibung Bezug genommen wird.

In Fig. 1a) ist ein typisches Tiefpaßfilter mit einem Serienwiderstand R und einem Parallelkondensator C dargestellt. Mit Hilfe der Technik geschalteter Kondensatoren läßt sich diese Schaltung dann gemäß Fig. 1b) ohne ohm'schen Widerstand ausbilden. Der Widerstand R ist ersetzt durch einen Kondensator mit dazu parallel liegendem Schalter, der von einem Signal $\phi_1$ intermittierend überbrückt werden kann, und zu dem in Reihe ein weiterer Schalter liegt, der von einem zweiten, nicht-überlappenden Signal $\overline{\phi}_2$ an den nachgeschalteten Kondensator C' periodisch gekoppelt wird.

In Fig. 2 ist eine Schaltung gezeigt, die zwischen einem Eingangsanschluß, der das Signal Vi empfängt, und einem Ausgangsanschluß liegt, der das Ausgangssignal Vo liefert. Der obere Belag des geschalteten Kondensators Cs ist mit dem Eingangsanschluß über zwei Transistorschalter T1 und T2 gekoppelt. Die beiden Transistorschalter T1 und T2 sind jeweils als IGFET ausgebildet und erhalten an ihrem Gate das Signal $\phi$ bzw. $\overline{\phi}$. Die Source-Drain-Strecke von T1 liegt zwischen dem Eingang und dem oberen Belag von Cs, das gleiche gilt für den Transistorschalter T2, wobei hier jedoch eine Kurzschlußverbindung zwischen Source und Drain vorhanden ist.

Fig. 3 zeigt das Ersatzschaltbild der in Fig. 2 dargestellten Anordnung. Zunächst soll lediglich der links in Fig. 2 und Fig. 3 dargestellte Transistorschalter betrachtet werden. Das Ersatzschaltbild enthält den ohm'schen Widerstand $Rds_{off}$, das ist der ohm'sche Widerstand in dem Kanal zwischen Source und Drain, wenn der Transistor ausgeschaltet ist.

Zwischen dem isolierten Gate und der Source sowie zwischen dem isolierten Gate und dem Drain gibt es eine (parasitäre) Kapazität $Cgs_{T1}$ bzw. $Cgd_{T1}$.

Fig. 4 zeigt stark übertrieben den Verlauf der Rückflanke des Signals $\phi$ bzw. der Vorderflanke des Signals $\overline{\phi}$. Innerhalb einer Zeitspanne $\Delta t$ fällt die Spannung von $\phi$ bzw. steigt die Spannung von $\overline{\phi}$ um $\Delta U$.

Ohne den Transistorschalter T2 wirkt also auf den zu schaltenden Kondensator Cs die Kapazität $Cgd_{t1}$. Damit ergibt sich allein durch die parasitäre Kapazität des Transistorschalters T1 eine Cs beeinflussende und folglich zu berücksichtigende Ladung gemäß folgender Gleichung:

$$\Delta Q = Cgs \cdot \Delta u \tag{1}$$

Bei der üblichen Ausgestaltung von Feldeffekttransistoren in integrierten Schaltungen kann zur Vereinfachung hier angenommen werden

$$Cgs = Cgd \tag{2}$$

Das heißt also, die parasitären Kapazitäten des isolierten Gates bezüglich Source und bezüglich Drain sind gleich groß.

Die durch den Transistorschalter ins Spiel gebrachte parasitäre Kapazität muß bei der Auslegung der Schaltung und deren Betrieb berücksichtigt werden, denn der Wert $\Delta Q$ gemäß obiger Gleichung (1) stellt eine Ladungsmenge dar, die zusätzlich zu der im Kondensator Cs gespeicherten Ladung transportiert werden muß. Ein fehlerhafter Gesamtladungstransfer führt zu einem fehlerhaften Betrieb der Schaltung insgesamt.

Mit Hilfe des zweiten Transistorschalters T2 in Fig. 2 können die Effekte der parasitären Kapazität zwischen dem Gate und dem Drain von T1 beseitigt werden.

Wie in dem in Fig. 3 gezeigten Ersatzschaltbild dargestellt ist, besitzt der zweite Transistorschalter T2 ebenfalls einen Reihenwiderstand und zwei Parallelkondensatoren, die jeweils so eingestellt sind, daß ihre Kapazität halb so groß ist wie zum Beispiel die parasitäre Kapazität zwischen dem isolierten Gate und dem Drain von T2. Wie im folgenden noch zu sehen sein wird, wird die parasitäre Kapazität $Cgd_{T1}$ kompensiert durch die beiden parasitären Kapazitäten des Transistorschalters T1, wenn dessen parasitäre Kapazitäten jeweils halb so groß sind wie die eine parasitäre Kapazität von T1. Dies ist in Fig. 3 rechts durch die Bezeichnungen $1/2\,(Cgd_{T2})$ bzw. $1/2\,(Cgs_{T2})$ angedeutet. Als kompensierte Ladung $\Delta Q$ erhält man dann unter der Voraussetzung, daß $Cgd_{T2} = 1/2\,(Cgs_{T1})$, aus

$$\Delta Q = (2.\ Cgd_{T2} - Cgs_{T1})\Delta u \qquad\qquad (3)$$

den gewünschten Wert

$$\Delta Q = 0$$

Mit der in Fig. 3 dargestellten Anordnung, also einem geschalteten Kondensator $C_s$, einem zwischen dessen einem Belag und dem Eingangsanschluß liegendem Transistorschalter T1 sowie einem dazu in Reihe geschalteten Kompensationsbauelement (Kompensationstransistor) T2 ergibt sich eine Anordnung, bei der unerwünschte parasitäre Effekte des Transistorschalters T1 kompensiert werden können.

Wenn man den Transistorschalter T1 auf möglichst kleiner Chipfläche ausbildet, läßt sich die Gesamtchipfläche der für zahlreiche geschaltete Kondensatoren benötigten Transistorschalter minimieren. Die kleinsten Abmessungen für einzelne Strukturen des integrierten Transistorschalters sind von mehreren Einflüssen vorgegeben, beispielsweise durch das spezielle Herstellungsverfahren zum Herstellen des IC-Chips. Betrachtet man das Ersatzschaltbild nach Fig. 3, so erkennt man, daß man den Transistorschalter T1 selbst nicht mit kleinstmöglichen Strukturen realisieren kann; denn damit die beiden parasitären Kondensatoren des Schalters T2 in Fig. 3 die halbe Kapazität von jeweils einem der beiden parasitären Kondensatoren des Transistorschalters T1 aufweisen, lassen sich allenfalls die Strukturen des Bauelements T2 minimieren, nicht aber die des Transistorschalters T1. Die Strukturen des Transistorschalters T1 müssen im wesentlichen doppelt so groß sein wie die des Bauelements T2.

Beim Schaltungsentwurf muß also zunächst die Struktur für das Bauelement T2 festgelegt werden, und ausgehend davon wird dann der Aufbau von T1 festgelegt, wobei dessen Abmessungen, insbesondere die Kanallänge (vergl. Länge 1min in Fig. 5) zwischen Source und Drain, doppelt so groß sind wie bei dem Bauelement T2.

Diese Randbedingungen sind nicht nur deshalb unerwünscht, weil man relativ viel Chipbelegungsfläche für die Schalter des geschalteten Kondensators benötigt. Weil die Verhältnisse so sind, wie sie anhand von Fig. 3 erläutert wurden, sind die parasitären Kapazitäten des Transistorschalters T1 auch relativ groß, und entsprechend groß ist auch die zu transferierende Ladungsmenge.

Der Erfindung liegt die Aufgabe zugrunde, eine integrierte Schaltung mit mindestens einem geschalteten Kondensator anzugeben, in der nur relativ wenig Chipbelegungsfläche benötigt wird und dennoch für jeden geschalteten Transistor das zugehörige Kompensationsbauelement vorhanden ist.

Gelöst wird diese Aufgabe erfindungsgemäß dadurch, daß das Kompensationsbauelement durch eine unvollständige Transistorstruktur gebildet ist, die ein Gate aufweist, welches an eine Drain-Zone oder eine Source-Zone des Transistorschalters angrenzt, an die der eine Belag des geschalteten Kondensators angeschlossen ist.

Die Erfindung bedeutet im Prinzip so etwas wie einen halben Transistor (1/2-Transistor). Dieser 1/2-Transistor enthält zum Beispiel ein Drain, welches gemeinsam mit dem Drain des Transistorschalters ausgebildet ist, und er enthält ein isoliertes Gate, welches der halben Kanallänge zwischen dem Drain und der Source des Transistorschalters entspricht. Durch diese Anordnung wird eine parasitäre Kapazität zwischen dem isolierten Gate des Kompensationsbauelements (des 1/2-Transistors) und dem Drain geschaffen, die der gesamten parasitären Kapazität des Kompensationsbauelements entspricht, also nur halb so groß ist wie bei einem aus einem vollständigen Transistor bestehenden Kompensationsbauelement. Die Größe des Gates entspricht der Hälfte der Größe des Gates des Transistorschalters. Damit ist das an sich optimale Ziel für die Kompensation erreicht, nämlich die Möglichkeit, die Struktur des Transistorschalters zu minimieren und dennoch dessen gesamte für den zu schaltenden Kondensator wirksame parasitäre Kapazität vollständig zu kompensieren.

In einer speziellen Ausgestaltung der Erfindung ist vorgesehen, daß der Transistorschalter zwei komplementäre FET-Transistoren aufweist, deren Gates ebenso wie die Gates zweier komplementärer Kompensationsbau

elemente mit gegenphasigen Steuersignalen gespeist werden. Geht man von einer minimalen parasitären Kapazität des Kompensationsbauelements aus, die man mit $Cgs_{min}$ bezeichnet, so ergibt sich entsprechend der obigen Gleichung (3) für das erfindungsgemäße Bauelement die Beziehung

$$\Delta Q = (Cgd_{T2} - Cgd_{T1}) \cdot \Delta u = (Cgd_{min} - Cgd_{min})\Delta u = 0 \qquad (4)$$

Im folgenden werden Ausführungsbeispiele anhand der Zeichnungen näher erläutert. Es zeigen:

**Fig. 1** ein RG-Glied und dessen mit Hilfe eines geschalteten Kondensators simulierte Ausführungsform;

**Fig. 2** einen geschalteten Kondensator mit Transistorschalter und Kompensationsschalter;

**Fig. 3** das Ersatzschaltbild der Schaltung nach Fig.2,

**Fig. 4** den Verlauf von Impulsflanken des Ansteuersignals für die Transistorschalter in Fig. 2 und 3;

**Fig. 5** eine Schnittansicht durch eine integrierte Schaltung gemäß der Erfindung;

**Fig. 6** eine modifizierte Ausführungsform der erfindungsgemäßen Schaltung in Form einer Prinzip-Darstellung; und

**Fig. 7** ein Ersatzschaltbild der in Fig. 5 dargestellten Struktur (mit dem in Fig. 5 nicht zu sehenden geschalteten Kondensator).

Die Figuren 1 bis 4 wurden oben bereits erläutert. Bevor auf eine spezielle Ausführungsform der Erfindung mit dem in Fig. 5 gezeigten spezifischen Layout eingegangen wird, soll eine Variante der erfindungsgemäßen Schaltung gem. Fig. 6 erläutert werden.

Die Schaltung nach Fig. 6 unterscheidet sich von der Schaltung nach Fig. 2 lediglich dadurch, daß die Schalteranordnung durch komplementäre Transistoren in zwei parallelen Signalzweigen mit je zwei in Reihe geschalteten Schaltern T1, T2 bzw. T3, T4 ausgebildet ist. Während die Steuerelektroden oder Gates der Schalter T1 und T2 die Signale $\phi_n$ bzw. $\overline{\phi}_n$ (für die n-Kanal-Transistoren) empfangen, wird den Gates der in dem parallelen Signalweg liegenden Schalter T3 und T4 das Signal $\phi_p$ bzw. $\overline{\phi}_p$ zugeführt (entsprechend den p-Kanal-Transistoren). Die Signale $\phi_n$ und $\overline{\phi}_p$ bzw. die Signale $\overline{\phi}_n$ und $\phi_p$ unterscheiden sich dadurch voneinander, daß sie umgekehrte Polarität besitzen. Man kann $\phi_n = \overline{\phi}_p$ und $\phi_p = \overline{\phi}_n$ verwenden. Man sieht, daß mit der in Fig. 6 dargestellten Schaltung ein schnellerer Ladungstransfer möglich ist als mit der Schaltung nach Fig. 2; denn durch die komplementären Transistoren wird über den gesamten Eingangsspannungshub eine gleichmäßig gute Leitfähigkeit erzielt.

Fig. 5 zeigt einen Schnitt durch eine integrierte Schaltung, die von dem erfindungsgemäßen Prinzip Gebrauch macht.

Auf einem p-leitenden Substrat 2 sind zwischen Feldoxidbereichen 4 der Schaltertransistor T1 gemäß Fig. 2 und das Kompensationsbauelement T2 ausgebildet. Die Verfahrensschritte, mit deren Hilfe die in Fig. 5 dargestellte Struktur erhalten wird, werden hier nicht mehr erläutert. Wie dem Fachmann ersichtlich ist, können hierzu bekannte photolithographische Verfahren eingesetzt werden, wie sie in der Halbleiterindustrie üblich sind.

In dem Bereich zwischen dem Feldoxid 4 sind zwei n-leitende Mulden 8 und 10 ausgebildet. Zwischen ihnen befindet sich der Kanal des Transistors T1. Über einer Isolierschicht 12 zwischen den beiden n-leitenden Mulden 8 und 10 befindet sich ein Gate 14.

Die n-leitende Zone 8 steht mit einem Source-Kontakt 20 in Verbindung mit dem Eingangsanschluß der Schaltung, der das Signal Vi empfängt. Das Gate 14 ist mit einem Gatekontakt 22 versehen, dem das Steuersignal $\overline{\phi}$ zugeführt wird. Die n-leitende Zone 10 ist die Drain-Zone und steht im Kontakt mit einem Drain-Anschluß 24, an den der in Fig. 2 oben gezeigte Belag des geschalteten Kondensators $C_s$ (in hier nicht näher dargestellter Weise) verbunden ist.

Gemäß dem rechts in Fig. 5 dargestellten Aufbau ist anders, als man dies durch die symbolische Darstellung des Bauelements T2 in Fig. 2 vermuten könnte, kein vollständiger Transistor, sondern nur ein halber Transistor (1/2-Transistor) ausgebildet. Er enhält als Drain-Zone die n-leitende Zone 10 gemeinsam mit dem Transistor T1. Zwischen dem rechts in Fig. 5 dargestellten Feldoxid 4 und der n-leitenden Zone 10 befindet sich auf der Oberfläche des p-Substrats eine Gateisolierschicht 28, und darauf ein Gate 18, welches über einen Gate-Anschluß 26 das Steuersignal $\phi$ empfängt.

In Fig. 5 erkennt man also, daß zum Kompensieren der parasitären Kapazität zwischen dem Gate 14 und dem Drain, das heißt der n-leitenden Zone 10 des Transistors T1, kein vollständiger Transistor verwendet wird, sondern nur ein halber Transistor, der zwischen seinem Gate 18 und der Drain-Zone 10 eine gewisse Kapazität aufweist, mit der die parasitäre Kapazität Cgd des Transistors T1 kompensiert wird.

Fig. 7 zeigt das Ersatzschaltbild zu der in Fig. 5 gezeigten Anordnung. Der ohm'sche Widerstand $Rds_{off}$ des Kompensationstransistors T2 in Fig. 2 ist ersetzt durch eine einfache Kapazität $Cgd_{T2}$.

Der Fachmann sieht, daß die in Fig. 7 gezeigte Ersatzschaltung leicht erweitert werden kann, um die in Fig. 6 dargestellte komplementäre Schaltungsanordnung wiederzuspiegeln.

In Fig. 5 erkennt man, daß man den "Kanal" zwischen der n-leitenden Zone 10 und dem benachbarten Feldoxid 4 mit sehr kleiner Länge $1_{min}/2$ ausbilden kann, während dann die Kanallänge des Transistors T1 doppelt so groß ist, nämlich $1_{min}$. Im Vergleich zu der Lösung mit zwei vollständigen Transistorschaltern, wie sie in Fig. 2 gezeigt sind, wird bei der Schaltung nach Fig. 5 und der Ersatzschaltung nach Fig. 7 also Chipfläche eingespart.

## Patentansprüche

1. Integrierte Schaltung mit mindestens einem geschalteten Kondensator (Cs), der zum Beispiel zum Simulieren eines ohm'schen Widerstands dient, und dessen einer Belag mit einem Signaleingang (Vi) über mindestens einen Transistorschalter (T1, T3), der Source, Drain und Gate aufweist, gekoppelt ist, dessen Gate (G) ein Steuersignal ($\phi$) in Form eines Impulszugs mit vorbestimmter Frequenz zugeführt wird, wobei zwischen dem Transistorschalter (T1, T3) und dem einen Kondensatorbelag ein Kompensationsbauelement (T2, T4) liegt, das gegenphasig zu dem Transistorschalter angesteuert wird, um die wirksame parasitäre Kapazität ($Cgd_{T1}$) zwischen dem Gate und dem Drain oder zwischen dem Gate und der Source des Transistorschalters zu kompensieren,
   **dadurch gekennzeichnet, daß**
   das Kompensationsbauelement (T2, T4) durch eine unvollständige Transistorstruktur gebildet wird, die ein Gate (18) aufweist, welches an eine Drain-Zone (10) oder eine Source-Zone des Transistorschalters (T1, T3) angrenzt, an die der eine Belag des geschalteten Kondensators (Cs) angeschlossen ist.

2. Integrierte Schaltung nach Anspruch 1,
   **dadurch gekennzeichnet**, daß der Transistorschalter (T1, T3) als Feldeffekttransistor mit isoliertem Gate (IGFET) ausgebildet ist, und daß das Kompensationsbauelement ebenfalls ein isoliertes Gate (18, 28) besitzt.

3. Integrierte Schaltung nach Anspruch 1 oder 2,
   **dadurch gekennzeichnet**, daß die Länge ($1_{min}/2$) des Gates (18, 28) des Kompensationsbauelements (T2, T4) etwa halb so groß ist wie die Länge ($1_{min}$) des Gates (12, 14) des Transistorschalters (T1, T3).

4. Integrierte Schaltung nach einem der Ansprüche 1 bis 3,
   **dadurch gekennzeichnet**, daß sie eine Parallelschaltung zweier Reihenschaltungen mit je einem Transistorschalter (T1, T3) und einem Kompensationsbauelement (T2, T4) aufweist, wobei die beiden Transistorschalter (T1, T3) einerseits und die beiden Kompensationsbauelemente andererseits komplementär zueinander sind und wobei die Gates der beiden Transistorschalter (T1, T3) einerseits und die Gates der beiden Kompensationsbauelemente (T3, T4) andererseits je mit gegenphasigen Steuersignalen beaufschlagt werden.

FIG.1a

$R$

$C$

FIG.1b

$\varnothing_1$

$\varnothing_2$

$C'$

FIG.2

$\varnothing$    $\overline{\varnothing}$

$V_i$    $V_o$

$T_1$    $T_2$

$C_s$

FIG.3

$C_{gs}T_1$    $\varnothing$    $\overline{\varnothing}$    $\frac{1}{2}C_{gs}T_2$

$V_i$    $V_o$

$Rds_{off}$    $Rds_{off}$

$C_{gd}T_1$    $\frac{1}{2}C_{gd}T_2$    $C_s$

**FIG.4**

**FIG.5**

**FIG.6**

**FIG.7**